# EUROPEAN PATENT SPECIFICATION

(11) **EP 1 702 337 B1**
(45) Date of publication and mention of the grant of the patent: **14.11.2018**
(21) Application number: 04772376.2
(22) Date of filing: 23.08.2004
(51) Int. Cl.: G11C 16/10, G11C 16/22, G11C 11/56

(54) **NONVOLATILE SEMICONDUCTOR MEMORY DEVICE WHICH USES SOME MEMORY BLOCKS IN MULTILEVEL MEMORY AS BINARY MEMORY BLOCKS**
NICHTFLÜCHTIGE HALBLEITERSPEICHERANORDNUNG WELCHE EINIGE SPEICHERBLÖCKE IM MULTIBITSPEICHER ALS BINARSPEICHERBLÖCKE BENUTZT
DISPOSITIF DE MÉMOIRE NON VOLATILE À SEMI-CONDUCTEURS UTILISANT DES BLOCS DANS UNE MÉMOIRE MULTINIVEAU SOUS FORME DE BLOCS DE MÉMOIRE BINAIRE

(30) Priority: 29.09.2003 JP 2003338545
(43) Date of publication of application: 20.09.2006
(73) Proprietor: Toshiba Memory Corporation, Tokyo 105-0023 (JP); SanDisk Technologies LLC, Plano, TX 75024 (US)
(72) Inventor: NAGASHIMA, Hiroyuki, Tokyo 105-8001 (JP); TANAKA, Tomoharu, Tokyo 105-8001 (JP); KAWAI, Koichi, Tokyo 105-8001 (JP); QUADER, Khandker N., Sunnyvale, CA 94089 (US)
(74) Representative: Hoffmann Eitle
(86) International application number: PCT/JP2004/012420
(87) International publication number: WO 2005/031751

(56) References cited:
- US-A- 5 982 663
- US-A1- 2002 057 595
- US-A1- 2003 007 384
- US-A1- 2003 126 513
- US-B1- 6 490 197

## Description

### CROSS-REFERENCE TO RELATED APPLICATIONS

This application is based upon and claims the benefit of priority from prior Japanese Patent Application No. 2003-338545, filed September 29, 2003.

### Technical Field

The present invention relates to an electrically rewritable nonvolatile semiconductor memory device and, more particularly, to a flash memory which selectively uses, as memory blocks that store binary information, some memory blocks in a memory cell array which stores multilevel information.

### Background Art

In many memory systems, a file allocation table (FAT) is necessary. The FAT is a block which stores the position of each file. The FAT must be rewritten every time a write or erase is executed for the memory system. For this purpose, the write speed must be as high as possible in the area where the FAT is written.

In current flash memories, normal memory cells (binary technique) which store 1-bit information in one cell and memory cells which use a multilevel technique capable of storing 2-bit information (or information of three or more bits) in one cell are known.

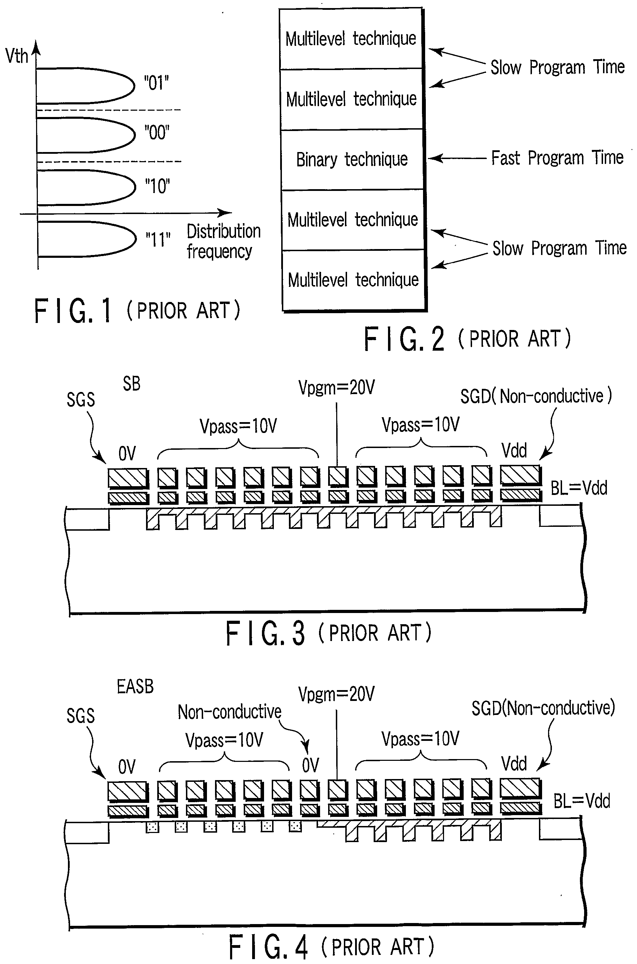

In a memory cell using the multilevel technique, for example, the distribution of a threshold voltage Vth of the memory cell is changed in four steps, as shown in FIG. 1. Two-bit information is stored by making "01", "00", "10", or "11" correspond to each distribution. When this multilevel technique is employed, the storage capacity can be doubled as compared to the binary technique.

In the flash memory that employs the multilevel technique, the write speed is lower than in the binary technique. As a measure against this, the memory cell array is divided into a plurality of blocks, and the multilevel technique is not used in a block such as a FAT that is frequently write-accessed, i.e., the write using the binary technique is selectively executed, as shown in FIG. 2, in order to increase the write speed. With this arrangement, a high-speed write is implemented by binary technique blocks while ensuring the storage capacity by multilevel technique blocks.

A NAND flash memory uses different write methods for the binary technique and multilevel technique. The binary technique uses a self-boost (SB) method. The multilevel technique uses an erased area self-boost (EASB) method. In both methods, a "0"-write is executed in the same way. A write voltage Vpgm (e.g., 20V) is applied to a selected word line (a control gate CG of a selected cell transistor). An intermediate voltage Vpass (e.g., 10V) is applied to unselected word lines. A bit line BL is set to 0V, and the gate of a select transistor SGD on the bit line side is set to a power supply voltage Vdd to set the select transistor SGD in the conductive state. Accordingly, electrons are injected to the floating gate of the selected cell transistor to increase the threshold voltage.

Conversely, the manner a "1"-write (non-write) is executed changes between the SB method and the EASB method. In the SB method, as shown in FIG. 3, the write voltage Vpgm (20V) is applied to a selected word line. The intermediate voltage Vpass (10V) is applied to unselected word lines. The bit line BL is set to the power supply voltage Vdd, and the gate of the select transistor SGD on the bit line side is set to the power supply voltage Vdd to set the select transistor SGD in the non-conductive state. In addition, the gate of a select transistor SGS on the common source line side is set to 0V to set the select transistor SGS in the non-conductive state, too. Hence, no electrons are injected into the floating gate of the selected cell transistor so that the threshold voltage maintains the erase state. As described above, in the SB method, the write for the selected cell transistor is executed while setting the cell transistors series-connected between the select transistors SGD and SGS in the conductive state.

On the other hand, in the EASB method, as shown in FIG. 4, the write voltage Vpgm (20V) is applied to a selected word line to set a word line adjacent to the source line side of the selected word line to 0V. The intermediate voltage Vpass (10V) is applied to remaining unselected word lines. The bit line BL is set to the power supply voltage Vdd, and the gate of the select transistor SGD on the bit line side is set to the power supply voltage Vdd to set the select transistor SGD in the non-conductive state. In addition, the gate of the select transistor SGS on the common source line side is set to 0V to set the select transistor SGS in the non-conductive state, too. Hence, no electrons are injected to the floating gate of the selected cell transistor so that the threshold voltage maintains the erase state. As described above, in the EASB method, the write for the selected cell transistor is executed while setting the cell transistor on the bit line side of the selected cell transistor in the conductive state, and the cell transistor adjacent to the source line side of the selected cell transistor in the non-conductive state. This method is necessary for reducing write errors in the write using the multilevel technique.

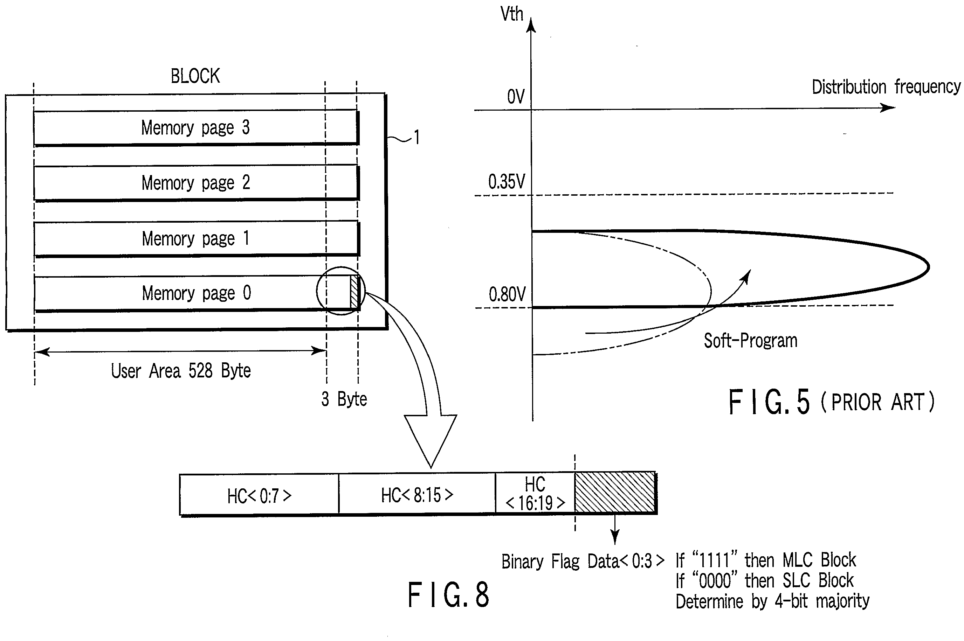

The cell transistor must be set to a threshold voltage that is cut off when the control gate voltage is 0V. For this reason, the erase method also changes. To execute the write by the EASB method, the threshold voltage of the cell transistor must not be too low. Hence, an operation (soft-program) must be performed to write the threshold voltage Vth, which is distributed by the erase as indicated by the alternate long and two-dashed line in FIG. 5, back to a certain level indicated by the solid line.

As described above, the binary technique and multilevel technique use different write and erase methods. If one memory cell array should include both binary technique blocks and multilevel technique blocks, the binary blocks and multilevel blocks must be discriminated after the erase.

For example, Jpn. Pat. Appln. KOKAI Publication No. 2001-210082 discloses a nonvolatile semiconductor memory device and a data storage system, in which a binary memory cell area and a multilevel memory cell area are separately formed in a memory cell array. In writing data, flag data that identifies the binary area or multilevel area is written for each word line. When the flag data is read out, a binary page or multilevel page can be identified so that a write or read corresponding to the binary technique or multilevel technique can be executed. In the technique disclosed in this prior art, however, the binary memory cell area and multilevel memory cell area are separately formed in advance. For this reason, the degree of freedom in selection by the user is low. Jpn. Pat. Appin. KOKAI Publication No. 2001-006374 discloses a semiconductor memory device and system which are selectively operated in a binary or multilevel mode. In the technique disclosed in this prior art, to selectively use a storage area as a binary area or multilevel area for each word line,
a binary/multilevel management table is prepared to indicate that a storage area is assigned to the binary area or multilevel area. The user can freely operate the device in the binary or multilevel mode. However, dedicated hardware is necessary for discriminating
between the binary blocks and the multilevel blocks, resulting in an increase in chip size.

As described above, for the conventional nonvolatile semiconductor memory devices, if blocks in the memory cell array should be selectively operated in the binary or multilevel mode, the degree of freedom in selection by the user becomes low. If the degree of freedom in block selection should be increased, dedicated hardware is necessary, resulting in an increase in chip size.

US 2002/0057595 A1 teaches a semi-conductor memory capable of realizing an efficient use of a memory area by providing for block areas which may be set to a four valued area for recording the data as four valued data or to a binary area for recording the data as binary data. On accessing a memory cell, a word line voltage for writing or a sense amplifier for reading will be switched in accordance with whether the data to be accessed is binary data or four valued data.

### Disclosure of Invention

According to one aspect of the present invention, there are provided nonvolatile semiconductor memory devices, according to independent claims 1 and 4. Further preferred embodiments are disclosed in the dependent claims.

### Brief Description of Drawings

FIG. 1 is a view showing the threshold voltage distribution of a memory cell using the multilevel technique; 20FIG. 2 is a block diagram for explaining a conventional nonvolatile semiconductor memory device using the multilevel technique and binary technique;
FIG. 3 is a sectional view for explaining a write operation by the SB method; 25FIG. 4 is a sectional view for explaining a write operation by the EASB method;
FIG. 5 is a view for explaining an erase operation to execute the write by the EASB method;
FIG. 6 is a block diagram showing the arrangement of a flash memory so as to explain a nonvolatile semiconductor memory device according to the embodiment of the present invention;
FIG. 7 is a circuit diagram showing the structure of the memory cell array shown in FIG. 6;
FIG. 8 is a schematic view showing the structure of each memory block shown in FIG. 7;
FIG. 9A is a flowchart showing erase procedures in the binary mode;
FIG. 9B is a flowchart showing erase procedures in the multilevel mode;
FIG. 10A is a flowchart showing write procedures in the binary mode;
FIG. 10B is a flowchart showing write procedures in the multilevel mode;
FIG. 11 is a flowchart showing procedures for reading out binary flag data to an external device;
FIG. 12A is a flowchart showing other write procedures in the binary mode; and
FIG. 12B is a flowchart showing other write procedures in the multilevel mode.

### Best Mode for Carrying Out the Invention

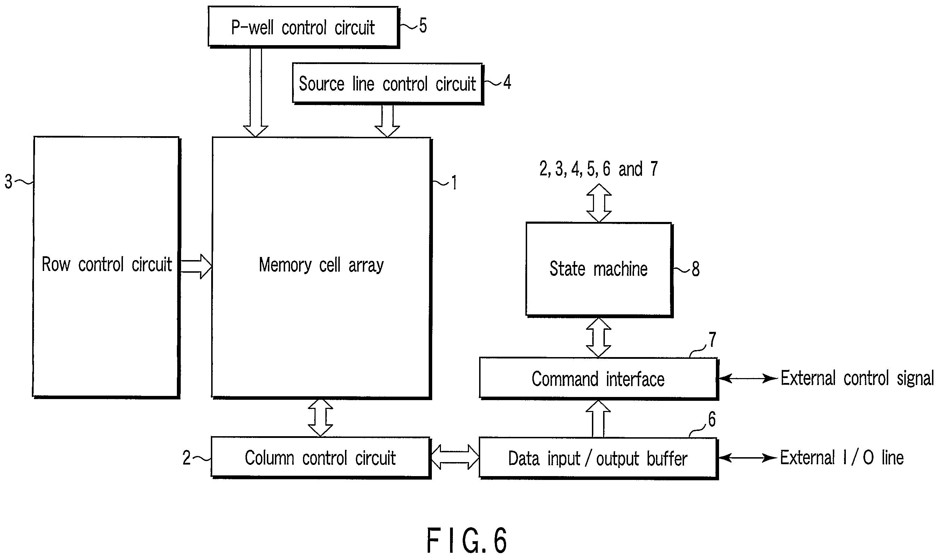

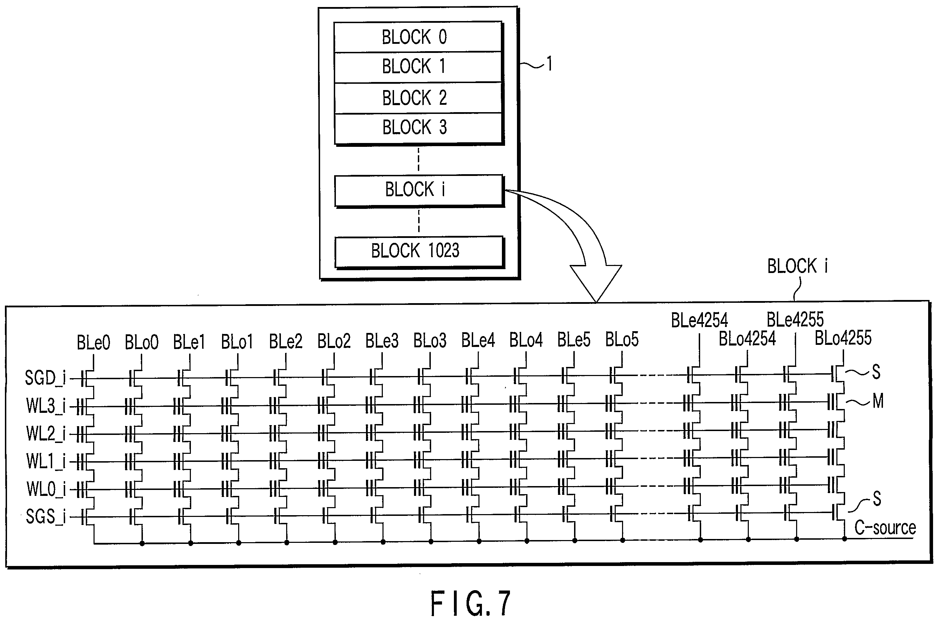

FIGS. 6 to 8 are views for explaining a nonvolatile semiconductor memory device according to the embodiment of the present invention. FIG. 6 is a block diagram showing the arrangement of a flash memory. FIG. 7 is a circuit diagram showing the structure of the memory cell array shown in FIG. 6. FIG. 8 is a schematic view showing the structure of each memory block shown in FIG. 7. A NAND flash memory is illustrated as an example, and a main part related to switching between the binary mode and the multilevel mode is shown.

A memory cell array 1 is constructed by arraying flash memory cells in a matrix. A column control circuit 2 is arranged adjacent to the memory cell array 1. The column control circuit 2 controls the bit lines of the memory cell array 1 to execute a data erase, data write, or data read for the memory cells. A row control circuit 3 is arranged to select a word line of the memory cell array 1 and apply a voltage necessary for the erase, write, or read to the word line. In addition, a source line control circuit 4 which controls the source line of the memory cell array 1 and a p-well control circuit 5 which controls the p-well in which the memory cell array 1 is formed are arranged.

A data input/output buffer 6 is connected to an external host (not shown) through an I/O line to receive write data, output readout data, and receive address data or command data. The data input/output buffer 6 sends received write data to the column control circuit 2 and receives readout data from the column control circuit 2. Additionally, to select a memory cell, the data input/output buffer 6 sends external address data to the column control circuit 2 or row control circuit 3 through a state machine 8. Also, the data input/output buffer 6 sends command data from the host to a command interface 7.

Upon receiving a control signal from the host, the command interface 7 determines whether the data input to the data input/output buffer 6 is write data, command data, or address data. If the data is command data, it is transferred to the state machine 8 as a reception command signal.

The state machine 8 manages the entire flash memory. The state machine 8 receives a command input from the host through the command interface 7 and manages the read, write, erase, and data input/output.

As shown in FIG. 7, the memory cell array 1 is divided into a plurality of (1,024) memory blocks BLOCK0 to BLOCK1023. These blocks are minimum units to be selectively used in the binary mode or multilevel mode. Each of the memory blocks BLOCK0 to BLOCK1023 is formed from 8,512 NAND memory units, as indicated by a representative memory block BLOCKi.

In this example, each NAND memory unit is constituted by connecting four memory cells (cell transistors) M in series. One terminal of the NAND memory unit is connected to bit lines BL (BLe0 to BLe4255 and BLo0 to BLo4255) through a select gate S connected to a select gate line SGD. The other terminal of the NAND memory unit is connected to a common source line C-source through the select gate S connected to a select gate line SGS. The control gate of each memory cell M is connected to a word line WL (WL0_i to WL3_i). A data write/read is executed independently for even-numbered bit lines BLe and odd-numbered bit lines BLo counted from 0. Of the 8,512 memory cells connected to one word line WL, 4,256 memory cells are connected to the even-numbered bit lines BLe, for which the data write/read is executed simultaneously. Data of the 4,256 memory cells each storing 1-bit data constitute a unit called a page. Similarly, 4,256 memory cells connected to the odd-numbered bit lines BLo constitute another page. The data write/read is executed simultaneously for the memory cells in the page.

In each block BLOCK shown in FIG. 7, the access operation such as the write, read, or erase is executed for each page (memory pages 0 to 3), as shown in FIG. 8. Each of memory pages 0 to 3 is formed from, e.g., a 528-byte user area and a 3-byte binary flag data area.

In the binary flag data area, normally, data called a hot count (HC) is stored to count the number of erases. Binary flag data that identifies the binary mode or multilevel mode is written in part of the hot count. Every time the erase is executed, data is written in the hot count to increment the count value by "1". To execute the write and erase for a multilevel memory device by selectively using the binary technique, the multilevel and binary modes must be discriminated in each memory block. In the multilevel memory device, when the erase is executed upon receiving a signal for the binary mode operation, predetermined flag data is written in the memory cells in the binary flag data area so that the block is recognized as a binary block. To use the block as a multilevel block (MLC Block), the binary flag data is set to "1111" (i.e., the memory cell erased state). To use the block as a binary block (SLC Block), "0000" is written as binary flag data. The 4-bit binary flag data is read out, and the block is identified as a multilevel block or binary block in accordance with the majority theory.

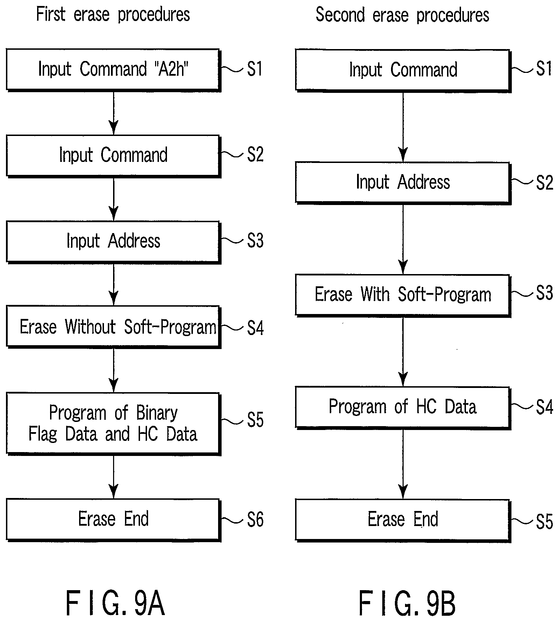

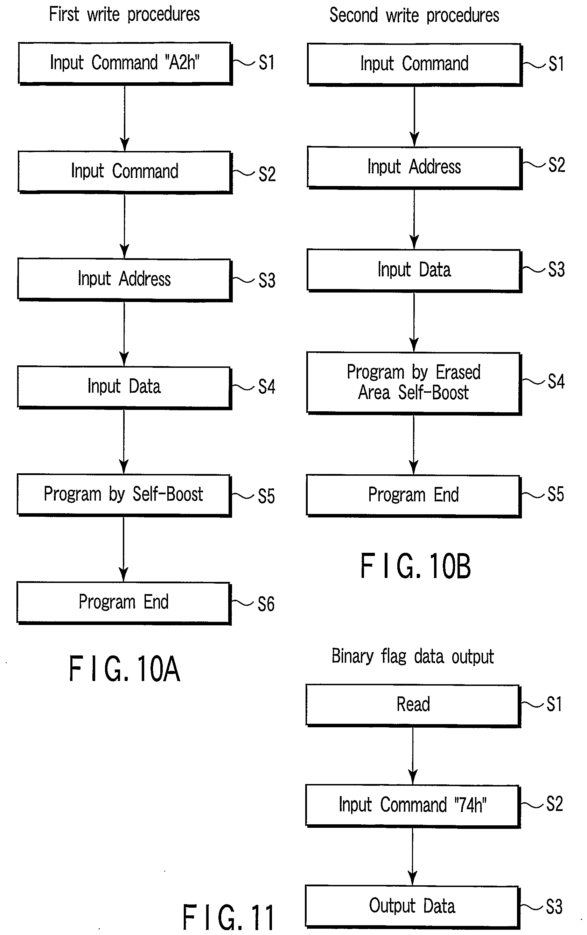

The operation of the NAND flash memory with the above arrangement shown in FIGS. 6 to 8 will be described next with reference to the flowcharts shown in FIGS. 9A, 9B, 10A, 10B, and 11. FIG. 9A shows erase procedures in the binary mode. FIG. 9B shows erase procedures in the multilevel mode. FIG. 10A shows write procedures in the binary mode. FIG. 10B shows write procedures in the multilevel mode. FIG. 11 shows procedures for reading out binary flag data to an external device.

When the operation is to be controlled by software using a controller, binary flag data is read out from each of the memory blocks BLOCK0 to BLOCK1023 in the memory cell array 1 at power-on time. Each of the memory blocks BLOCK0 to BLOCK1023 is recognized in advance as a block to be accessed in the binary sequence or a block to be accessed in the multilevel sequence.

On the basis of the recognition result, the erase is executed for a memory block to be write-accessed in the binary mode in accordance with the first procedures shown in FIG. 9A. In the erase, first, a command "A2h" that indicates a binary memory block is input from the host to the state machine 8 through the command interface 7 (S1). Next, an erase command that indicates the first erase procedures is input from the host and set in the state machine 8 (S2). Address data from the host is received, and an address to select a memory block to be erased is set in the state machine 8 (S3). The memory block to be erased is erased (without soft-program) (S4). Subsequently, binary flag data to identify the binary block and HC data are written in the memory cells in the binary flag data area (S5). To write the binary flag data, the HC data write sequence that is normally executed to count the number of times of erase is used. In other words, when the erase for the binary memory block is executed, the flag is automatically set by the state machine 8. In this way, the erase operation is ended (S6).

On the other hand, for a memory block to be write-accessed in the multilevel mode, the erase is executed in accordance with the second procedures shown in FIG. 9B. First, an erase command is input from the host through the command interface 7 and set in the state machine 8 (S1). Next, address data is input from the host, and an address to select a memory block to be erased is set in the state machine 8 (S2). After the erase is executed for the selected memory block, soft-program is executed to set a threshold voltage Vth at a predetermined level (S3). Subsequently, HC data is written (S4), and the erase operation is ended (S5).

The write operation will be described next.
On the basis of the recognition result which indicates that a block should be accessed in the binary sequence or multilevel sequence, for a memory block for which the erase has been executed in accordance with the first erase procedures, binary data is written in accordance with the first write procedures shown in FIG. 10A. More specifically, a command "A2h" that indicates a binary memory block is input from the host through the command interface 7 and set in the state machine 8 (S1). A write command is input from the host through the command interface 7 and set in the state machine 8 (S2). Address data is input from the host, and an address to select a memory block to be write-accessed is set in the state machine 8 (S3). This address is set for each page of the memory block to be write-accessed. Write data for one page (528 bytes) is input and set (S4). Then, the data is written by the SB method (S5). When all data are written, the write operation is ended (S6). If data to be written remains even after.the end of the write in memory page 0, steps S2 to S6 are repeatedly sequentially executed for memory pages 1 to 3. In this data write, error correction is executed by using an ECC technique.

For a memory block for which the erase has been executed in accordance with the second erase procedure, multilevel data is written in accordance with the second write procedures shown in FIG. 10B. First, a multilevel write command is input from the host through the command interface 7 and set in the state machine 8 (S1). Next, address data is input from the host, and an address to select a memory block to be write-accessed is set in the state machine 8 (S2). This address is set for each page of the block to be write-accessed. Write data for one page (528 bytes) is input and set (S3). Then, the data is written by the EASB method (S4). When all data are written, the write operation is ended (S5). If data to be written remains even after the end of the write in memory page 0, steps S1 to S5 are repeatedly sequentially executed for memory pages 1 to 3. In this data write, error correction is executed by using an ECC technique.

To read out the binary flag data to the external device, as shown in FIG. 11, a read command is input from the host and set in the state machine 8 (S1). Subsequently, a status "74h" is set from the host to the state machine 8 (S2). Accordingly, the data is output through the command interface 7 and data input/output buffer 6 (S3).

In the above embodiment, the binary flag data is read out at power-on time, and the operation is controlled by software using a controller. The same operation as described above can be implemented by hardware.

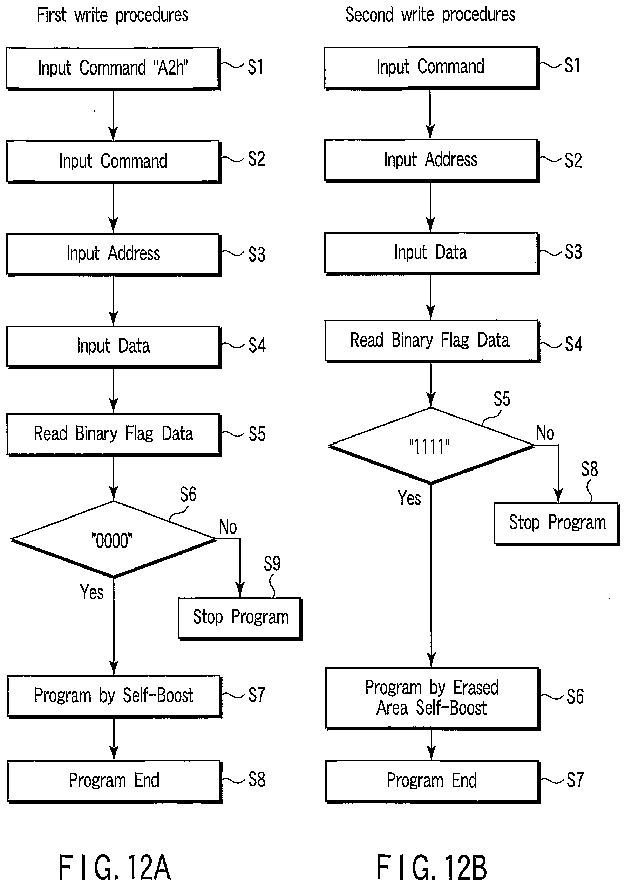

In this, case, after the erase is executed in accordance with the first or second erase procedures shown in FIG. 9A or 9B, the write is executed in accordance with the write procedures shown in the flowchart of FIG. 12A or 12B. More specifically, for a memory block for which the erase has been executed in accordance with the first erase procedures, binary data is written in accordance with the first write procedures shown in FIG. 12A. First, a command "A2h" that indicates a binary memory block is input from the host through the command interface 7 and set in the state machine 8 (S1). A write command is input from the host through the command interface 7 and set in the state machine 8 (S2). Address data is input from the host, and an address to select a memory block to be write-accessed is set in the state machine 8 (S3). This address is set for each page of the memory block to be write-accessed. Write data for one page (528 bytes) is input and set (S4). Next, the binary flag data of the block is read out (S5) to determine whether the block is a block to be write-accessed in the binary sequence or multilevel sequence (S6). When the readout binary flag data is "0000", the data is written by the SB method (S7). When all data are written, the write operation is ended (S8). If data to be written remains even after the end of the write in memory page 0, steps S2 to S8 are repeatedly sequentially executed for memory pages 1 to 3. When the readout binary flag data is not "0000" ("1111"), the write operation is stopped without executing the write command (S9). At this time, whether the block is a binary block or multilevel block is determined in accordance with a 4-bit majority theory. Accordingly, the binary flag data can be error-corrected.

For a memory block for which the erase has been executed in accordance with the second erase procedure, multilevel data is written in accordance with the second write procedures shown in FIG. 12B. First, a multilevel write command is input from the host through the command interface 7 and set in the state machine 8 (S1). Next, address data is input from the host, and an address to select a memory block to be write-accessed is set in the state machine 8 (S2). This address is set for each page of the block to be write-accessed. Write data for one page (528 bytes) is input and set (S3). Then, the binary flag data of the block is read out (S4) to recognize whether the block is a block to be write-accessed in the binary sequence or multilevel sequence (S5). When the readout binary flag data is "1111", the data is written by the EASB method (S6). When all data are written, the write operation is ended (S7). If data to be written remains even after the end of the write in memory page 0, steps S1 to S7 are repeatedly sequentially executed for memory pages 1 to 3. When the readout binary flag data is not "1111" ("0000"), the write operation is stopped without executing the write command (S8). As a matter of course, whether the block is a binary block or multilevel block is determined in accordance with the 4-bit majority theory. Accordingly, the binary flag data can be error-corrected.

According to the nonvolatile semiconductor memory device having the above arrangement, the following effects can be obtained.
(1) In the memory cell array formed as a multilevel memory cell array, a block to be used in the binary mode can be freely selected. For this reason, an arbitrary memory block in the memory cell array can be selectively operated in the binary mode or multilevel mode at a high degree of freedom. In addition, when a block such as a FAT that is to be frequently rewritten is used in the binary mode, the write speed can be greatly increased.
(2) The binary flag data can be placed in any memory page of any memory block and therefore can be placed anywhere in a remaining area. In addition, since the binary flag data is written in the memory block to be used in the binary mode, no dedicated hardware is necessary. Hence, the block can be used in the binary mode without increasing the chip size.
(3) In the erase using the multilevel technique, soft-program is executed after the erase of a cell. Since the threshold voltage of a cell can exceed 0V, the reliability is lower than the binary technique. However, in the erase operation by the binary technique, no soft-program is executed. Hence, a high reliability can be ensured.
(4) For a memory block for which the binary flag is set (a memory block to be accessed in the binary mode), the write using the multilevel technique is rejected and cannot be executed. Accordingly, the write speed and reliability can be ensured for the memory block.
(5) The binary flag data can be output to the external device through the interface (data input/output buffer 6 and command interface 7). Hence, it can easily be identified from the external device whether a memory block is a binary block or multilevel block.
(6) The binary flag data is written in a plurality of memory cells in each memory cell block. When the binary flag data is read out, error correction is executed in accordance with the majority theory. Hence, any recognition error for the memory block can be prevented.

As described above, in the nonvolatile semiconductor memory device according to this embodiment, when the erase is executed simultaneously with the input of a binary mode command, predetermined flag data is written in predetermined memory cells of a given memory page so that the block is recognized as a binary mode block. The write time of a multilevel NAND flash memory is longer than that of a binary product. However, when some memory blocks are selectively set as binary blocks and write-accessed by the SB method, the write time for the blocks can be shortened. Especially, when a block such as a FAT that is frequently rewritten is set as a binary mode block, the write speed can be increased. In addition, since the reliability of the binary mode is higher than that of the multilevel mode, the reliability can also be ensured. Furthermore, when the flag data is written in a plurality of memory cells, and error correction is executed in accordance with the majority theory in reading out the flag data, the reliability can further be increased. Since the flag data can be output to the external device, the block set in the binary mode can easily be confirmed from the external device.

With this arrangement, an arbitrary memory block in the memory cell array can be selectively operated in the binary mode or multilevel mode with a high degree of freedom.

In the above embodiment, a NAND flash memory has been described as an example of a nonvolatile semiconductor memory device. However, the present invention can also be applied to a semiconductor integrated circuit device in which a NAND flash memory and logic circuit are embedded, or a semiconductor integrated circuit device called a SOC in which a system is formed in one chip. The present invention can also be applied to an IC card or memory card in which the nonvolatile semiconductor memory device is mounted on a card-shaped package or various memory systems such as a system using the memory card.

As described above, according to one aspect of this invention, each memory block in the memory cell array can freely be selected, and data can be written in accordance with the first or second write procedures. The flag data can be placed in any memory page of any memory block and therefore can be placed anywhere in a remaining area. In addition, since the flag data is written in the memory block to be write-accessed or erased, no dedicated hardware is necessary, and any increase in chip size can be prevented. With this arrangement, an arbitrary memory block in the memory cell array can be selectively operated in the binary mode or multilevel mode with a high degree of freedom.

According to the embodiment of the present invention, a nonvolatile semiconductor memory device can be obtained, which can selectively operate an arbitrary memory block in a memory cell array in the binary mode or multilevel mode with a high degree of freedom without increasing the chip size.

## Claims

1. A nonvolatile semiconductor memory device comprising:
a memory cell array (1) constituted by memory blocks having electrically rewritable nonvolatile semiconductor memory cells (M), an arbitrary memory block in the memory cell array being selectively operated in a binary mode or a multilevel mode;
an interface (6, 7) that communicates with an external
device;
a storage configured to store data for discriminating between a binary mode operation to write data to a memory cell (M) in the memory blocks and a multilevel mode operation to write data to a memory cell in the memory blocks, the storage being part of the memory cells (M) of the memory blocks (BLOCK 0 to BLOCK 1023), the data being flag data stored in the memory cells (M), and the flag data being written to the memory cells (M) after the data being written by the first write procedures; and
a write circuit which writes data in the memory cell array in accordance with a data write command input to the interface,**characterized in that**:
the write circuit (2, 3, 4, 5, 8) writes data to the memory cell array (1) by first write procedures for writing binary data to the memory cell (M) or second write procedures for writing multilevel data to the memory cell (M); and
the write circuit (2, 3, 4, 5, 8) determines (S6) whether to execute or not to execute the data write command, based on the flag data in the memory cells, when the data write command is input from the interface (6, 7) by the first write procedures.

2. The device according to claim 1, wherein the flag data can be output to the external device through the interface.

3. The device according to claim 1, wherein the flag data is written in a plurality of memory cells in each memory block, and when the flag data is read out, error correction is executed in accordance with a majority theory.

4. A nonvolatile semiconductor memory device comprising:
a memory cell array (1) constituted by memory blocks having electrically rewritable nonvolatile semiconductor memory cells (M), an arbitrary memory block in the memory cell array being selectively operated in a binary mode or a multilevel mode the memory blocks being usable in a binary mode and a multilevel mode;
an interface (6, 7) that communicates with an external
device;
a storage configured to store data for discriminating between a binary mode operation to write data to a memory cell in the memory blocks and a multilevel mode operation to write data to a memory cell in the memory blocks, the storage being part of the memory cells (M) of the memory blocks (BLOCK 0 to BLOCK 1023), the data being flag data stored in the memory cells (M), and the flag data being written to the memory cells (M) after the data being written by the first write procedures;
a write circuit which writes data to the memory cell array in accordance with a data write command input to the interface;
an erase circuit which erases data for each memory cell block in accordance with a data erase command input to the interface; and
**characterized in that**:
the erase circuit (2, 3, 4, 5, 8) erases data for each memory cell block by first erase procedures for writing data in the memory cells (M) in the binary mode or second erase procedures for writing data in the memory cells (M) in the multilevel mode, in accordance with a data erase command input to the interface (6, 7), the erase circuit (2, 3, 4, 5, 8) executing an erase of the memory cells (M) in a selected memory block by using the first erase procedures and writing data erased by the first erase procedures or the second erase procedures to the storage, when the data erase command by the first erase procedures is input from the interface (6, 7); and
the write circuit (2, 3, 4, 5, 8) writes data for each page of each memory block (BLOCK0 to BLOCK1023) by first write procedures for writing data to the memory cells (M) in the binary mode when the erase is executed by using the first erase procedures or by second write procedures for writing data to the memory cells (M) in the multilevel mode when the erase is executed by using the second erase procedures in accordance with a data write command input to the interface (6, 7), the write circuit (2, 3, 4, 5, 8) executing the write command, which is input from the interface (6, 7) by the first write procedures, when the flag data in the memory cells_has a first value and not executing the data write command when the flag data has a second value.

5. The device according to claim 4, wherein the flag data can be output to the external device through the interface.

6. The device according to claim 4, wherein the flag data is written in a plurality of memory cells in each memory block, and when the flag data is read out, error correction is executed in accordance with a majority theory.

## Patentansprüche

1. Nichtflüchtiges Halbleiterspeichergerät, umfassend:
eine Speicherzellengruppierung (1), die durch Speicherblöcke mit elektrisch wiederbeschreibbaren nichtflüchtigen Halbleiterspeicherzellen (M) gebildet ist, wobei ein beliebiger Speicherblock in der Speicherzellengruppierung selektiv in einem Binärmodus oder einem Mehrebenenmodus betrieben wird;
eine Schnittstelle (6, 7), die mit einem externen Gerät kommuniziert;
einen Speicher, der zum Speichern von Daten zum Unterscheiden zwischen einem Binärmodusbetrieb zum Schreiben von binären Daten in Speicherzellen (M) im Speicherblock und einem Mehrebenenmodusbetrieb zum Schreiben von Mehrebenendaten in Speicherzellen (M) im Speicherblock konfiguriert ist, wobei der Speicher ein Teil der Speicherzellen (M) von jedem Speicherblock (BLOCK 0 bis BLOCK 1023) ist, wobei die Daten binäre Flag-Daten sind, die in Speicherzellen (M) von jedem Speicherblock gespeichert sind, und wobei die binären Flag-Daten in die Speicherzellen (M) geschrieben werden, nachdem Daten durch die ersten Schreibprozeduren, die binäre Daten schreiben, geschrieben wurden; und
einen Schreibschaltkreis, der zum Schreiben von Daten in die Speicherzellengruppierung gemäß einer Datenschreibbefehlseingabe an die Schnittstelle konfiguriert ist, **dadurch gekennzeichnet, dass**:
der Schreibschaltkreis (2, 3, 4, 5, 8) Daten durch erste Schreibprozeduren, die binäre Daten in die Speicherzellen (M) schreiben, oder zweite Schreibprozeduren, die Mehrebenendaten in die Speicherzellen (M) schreiben, in die Speicherzellengruppierung (1) schreibt; und
der Schreibschaltkreis (2, 3, 4, 5, 8) bestimmt (S6), den Datenschreibbefehl auf Grundlage der binären Flag-Daten in den Speicherzellen auszuführen oder nicht auszuführen, wenn der Datenschreibbefehl von der Schnittstelle (6, 7) durch die ersten Schreibprozeduren eingegeben wird.

2. Gerät nach Anspruch 1, wobei die binären Flag-Daten durch die Schnittstelle an das externe Gerät ausgegeben werden können.

3. Gerät nach Anspruch 1, wobei die binären Flag-Daten in eine Vielzahl von Speicherzellen in jedem Speicherblock geschrieben werden, und wenn die binären Flag-Daten ausgelesen werden, Fehlerkorrektur gemäß einer Mehrheitstheorie ausgeführt wird.

4. Nichtflüchtiges Halbleiterspeichergerät, umfassend:
eine Speicherzellengruppierung (1), die durch Speicherblöcke mit elektrisch wiederbeschreibbaren nichtflüchtigen Halbleiterspeicherzellen (M) gebildet ist, wobei ein beliebiger Speicherblock in der Speicherzellengruppierung selektiv in einem Binärmodus oder einem Mehrebenenmodus betrieben wird;
eine Schnittstelle (6, 7), die mit einem externen Gerät kommuniziert;
einen Speicher, der zum Speichern von Daten zum Unterscheiden zwischen einem Binärmodusbetrieb zum Schreiben von binären Daten in eine Speicherzelle in den Speicherblöcken und einem Mehrebenenmodusbetrieb zum Schreiben von Mehrebenendaten in eine Speicherzelle in den Speicherblöcken konfiguriert ist, wobei der Speicher ein Teil der Speicherzellen (M) von jedem Speicherblock (BLOCK 0 bis BLOCK 1023) ist, wobei die Daten binäre Flag-Daten sind, die in den Speicherzellen (M) gespeichert sind, und wobei die binären Flag-Daten in die Speicherzellen (M) geschrieben werden, nachdem Daten durch die ersten Schreibprozeduren, die binäre Daten schreiben, geschrieben wurden; und
einen Schreibschaltkreis, der zum Schreiben von Daten in die Speicherzellengruppierung gemäß einer Datenschreibbefehlseingabe an die Schnittstelle konfiguriert ist;
einen Löschschaltkreis, der zum Löschen von Daten für jeden Speicherzellenblock gemäß einer Datenlöschbefehlseingabe an die Schnittstelle konfiguriert ist; und
**dadurch gekennzeichnet, dass**:
der Löschschaltkreis (2, 3, 4, 5, 8) zum Löschen von Daten für jeden Speicherzellenblock durch erste Löschprozeduren zum Schreiben von Daten in den Speicherzellen (M) im Binärmodus oder zweite Löschprozeduren zum Schreiben von Daten in den Speicherzellen (M) im Mehrebenenmodus konfiguriert ist, gemäß einer Datenlöschbefehlseingabe an die Schnittstelle (6, 7), wobei der Löschschaltkreis (2, 3, 4, 5, 8) ein Löschen der Speicherzellen (M) in einem ausgewählten Speicherblock unter Anwendung der ersten Löschprozeduren und Speichern von binären Flag-Daten zum Unterscheiden zwischen den ersten Löschprozeduren oder den zweiten Löschprozeduren im Speicher ausführt, wenn der Datenlöschbefehl von der Schnittstelle (6, 7) durch die ersten Löschprozeduren eingegeben wird; und
der Schreibschaltkreis (2, 3, 4, 5, 8) zum Schreiben von Daten für jede Seite von jedem Speicherblock (BLOCK 0 bis BLOCK 1023) durch erste Schreibprozeduren, die Daten in die Speicherzellen (M) im Binärmodus schreiben, wenn das Löschen unter Verwendung der ersten Löschprozeduren ausgeführt wird, oder durch zweite Schreibprozeduren konfiguriert ist, die Daten in die Speicherzellen (M) im Mehrebenenmodus schreiben, wenn das Löschen unter Verwendung der zweiten Löschprozeduren gemäß einer Datenschreibbefehlseingabe an die Schnittstelle (6, 7) ausgeführt wird, wobei der Schreibschaltkreis (2, 3, 4, 5, 8) den Schreibbefehl ausführt, der von der Schnittstelle (6, 7) durch die ersten Schreibprozeduren eingegeben wird, wenn die binären Flag-Daten in den Speicherzellen einen ersten Wert aufweisen, und der Datenschreibbefehl nicht ausgeführt wird, wenn die Flag-Daten einen zweiten Wert aufweisen.

5. Gerät nach Anspruch 4, wobei die binären Flag-Daten durch die Schnittstelle an das externe Gerät ausgegeben werden können.

6. Gerät nach Anspruch 4, wobei die binären Flag-Daten in eine Vielzahl von Speicherzellen in jedem Speicherblock geschrieben werden, und wenn die binären Flag-Daten ausgelesen werden, Fehlerkorrektur gemäß einer Mehrheitstheorie ausgeführt wird.

## Revendications

1. Dispositif de mémoire non volatile à semi-conducteurs comprenant :
un réseau de cellules de mémoire (1) constitué par des blocs de mémoire ayant des cellules de mémoire non volatile électriquement réinscriptibles à semi-conducteurs (M), un bloc de mémoire arbitraire dans le réseau de cellules de mémoire fonctionnant sélectivement dans un mode binaire ou dans un mode multiniveau ;
une interface (6, 7) qui communique avec un dispositif externe ;
un élément de stockage configuré pour stocker des données pour faire une discrimination entre un fonctionnement en mode binaire pour écrire des données binaires vers des cellules de mémoire (M) dans le bloc de mémoire et un fonctionnement en mode multiniveau pour écrire des données multiniveaux vers des cellules de mémoire (M) dans le bloc de mémoire, l'élément de stockage faisant partie des cellules de mémoire (M) de chaque bloc de mémoire (BLOC 0 à BLOC 1023), les données étant des données de drapeau binaires stockées dans des cellules de mémoire (M) de chaque bloc de mémoire, et les données de drapeau binaires étant écrites vers les cellules de mémoire (M) après que les données ont été écrites par les premières procédures d'écriture écrivant de données binaires ; et
un circuit d'écriture configuré pour écrire des données dans le réseau de cellules de mémoire selon une commande d'écriture de données entrée vers l'interface, **caractérisé en ce que** :
le circuit d'écriture (2, 3, 4, 5, 8) écrit des données vers le réseau de cellules de mémoire (1) par des premières procédures d'écriture écrivant des données binaires vers les cellules de mémoire (M) ou par des secondes procédures d'écriture écrivant des données multiniveaux vers les cellules de mémoire (M) ; et
le circuit d'écriture (2, 3, 4, 5, 8) détermine (S6) s'il faut exécuter ou ne pas exécuter la commande d'écriture de données, sur la base des données de drapeau binaires dans les cellules de mémoire, lorsque la commande d'écriture de données est entrée depuis l'interface (6, 7) par les premières procédures d'écriture.

2. Dispositif selon la revendication 1, dans lequel les données de drapeau binaires peuvent être délivrées en sortie vers le dispositif externe par le biais de l'interface.

3. Dispositif selon la revendication 1, dans lequel les données de drapeau binaires sont écrites dans une pluralité de cellules de mémoire dans chaque bloc de mémoire et, lorsque les données de drapeau binaires sont lues, une correction d'erreur est exécutée selon une théorie majoritaire.

4. Dispositif de mémoire non volatile à semi-conducteurs comprenant :
un réseau de cellules de mémoire (1) constitué par des blocs de mémoire ayant des cellules de mémoire non volatile électriquement réinscriptibles à semi-conducteurs (M), un bloc de mémoire arbitraire dans le réseau de cellules de mémoire fonctionnant sélectivement dans un mode binaire ou dans un mode multiniveau ;
une interface (6, 7) qui communique avec un dispositif externe ;
un élément de stockage configuré pour stocker des données pour faire une discrimination entre un fonctionnement en mode binaire pour écrire des données binaires vers une cellule de mémoire dans les blocs de mémoire et un fonctionnement en mode multiniveau pour écrire des données multiniveaux vers une cellule de mémoire dans les blocs de mémoire, l'élément de stockage faisant partie des cellules de mémoire (M) de chaque bloc de mémoire (BLOC 0 à BLOC 1023), les données étant des données de drapeau binaires stockées dans les cellules de mémoire (M), et les données de drapeau binaires étant écrites vers les cellules de mémoire (M) après que les données ont été écrites par les premières procédures d'écriture écrivant des données binaires ; et
un circuit d'écriture configuré pour écrire des données vers le réseau de cellules de mémoire selon une commande d'écriture de données entrée vers l'interface ;
un circuit d'effacement configuré pour effacer des données pour chaque bloc de cellules de mémoire selon une commande d'effacement de données entrée vers l'interface ; et
**caractérisé en ce que** :
le circuit d'effacement (2, 3, 4, 5, 8) est configuré pour effacer des données pour chaque bloc de cellules de mémoire par des premières procédures d'effacement pour écrire des données dans les cellules de mémoire (M) dans le mode binaire ou par des secondes procédures d'effacement pour écrire des données dans les cellules de mémoire (M) dans le mode multiniveau, selon une commande d'effacement de données entrée vers l'interface (6, 7), le circuit d'effacement (2, 3, 4, 5, 8) exécutant un effacement des cellules de mémoire (M) dans un bloc de mémoire sélectionné à l'aide des premières procédures d'effacement et stockant des données de drapeau binaires pour faire une discrimination entre les premières procédures d'effacement ou les secondes procédures d'effacement vers l'élément de stockage, lorsque la commande d'effacement de données par les premières procédures d'effacement est entrée depuis l'interface (6, 7) ; et
le circuit d'écriture (2, 3, 4, 5, 8) est configuré pour écrire des données pour chaque page de chaque bloc de mémoire (BLOC 0 à BLOC 1023) par des premières procédures d'écriture écrivant des données vers les cellules de mémoire (M) dans le mode binaire lorsque l'effacement est exécuté à l'aide des premières procédures d'effacement, ou par des secondes procédures d'écriture écrivant des données vers les cellules de mémoire (M) dans le mode multiniveau lorsque l'effacement est exécuté à l'aide des secondes procédures d'effacement selon une commande d'écriture de données entrée vers l'interface (6, 7), le circuit d'écriture (2, 3, 4, 5, 8) exécutant la commande d'écriture, qui est entrée depuis l'interface (6, 7) par les premières procédures d'écriture, lorsque les données de drapeau binaires dans les cellules de mémoire ont une première valeur et n'exécutant pas la commande d'écriture de données lorsque les données de drapeau ont une seconde valeur.

5. Dispositif selon la revendication 4, dans lequel les données de drapeau binaires peuvent être délivrées en sortie vers le dispositif externe par le biais de l'interface.

6. Dispositif selon la revendication 4, dans lequel les données de drapeau binaires sont écrites dans une pluralité de cellules de mémoire dans chaque bloc de mémoire et, lorsque les données de drapeau binaires sont lues, une correction d'erreur est exécutée selon une théorie majoritaire.
